# EUROPEAN PATENT SPECIFICATION

(11) **EP 2 375 287 B1**
(45) Date of publication and mention of the grant of the patent: **05.06.2013**
(21) Application number: 10013375.0
(22) Date of filing: 06.10.2010
(51) Int. Cl.: B41C 1/10

(54) **Radiation sensitive composition**
Strahlungsempfindliche Zusammensetzung
Composition sensible au rayonnement

(30) Priority: 08.04.2010 TW 99110838
(43) Date of publication of application: 12.10.2011
(73) Proprietor: Founder Fine Chemical Industry Co., Ltd., Taiwan 235 (TW); Wang, Tung-Chi, Taiwan 235 (TW); Yeh, Ching-Yu, Taiwan 235 (TW)
(72) Inventor: Yeh, Ching-Yu, Yilan County 269, Taiwan 235 (TW); Yang, Ming-Hwa, Yilan County 269, Taiwan 235 (TW); Lin, Min-Shyan, Yilan County 269, Taiwan 235 (TW); Chen, Shih-Chieh, Yilan County 269, Taiwan 235 (TW)
(74) Representative: Ter Meer Steinmeister & Partner

(56) References cited:
- US-A- 4 696 886
- US-A- 5 340 699
- US-A- 5 770 750
- US-A- 6 166 151
- US-A1- 2006 246 377
- US-A1- 2007 224 550
- US-A1- 2008 118 868

## Description

### BACKGROUND OF THE INVENTION

### Field of the Invention

This invention generally relates to radiation sensitive compositions used in lithographic printing plates.

### Description of Prior Art

The feature of lithographic printing is that the image area retaining ink and non-image area retaining water are on a lithographic printing plate, wherein the image area retains oil and repels water and the non-image area retains water and repels oil. The operation of lithographic printing uses the immiscibility of oil (oily materials or ink) and water. A non-image of a lithographic printing plate is firstly moistened with water to form a water-retained and oil-repelled water film. Then ink is applied to the lithographic printing plate wherein the image area accepts ink. Pressure is applied during printing process such that the ink on the image area containing images or texts is transferred to the surface of papers or printable objects via a blanket. Typically, the ink is firstly transferred to the blanket, the intermediate material. Then the ink transferred onto the blanket is further transferred to the printable surface of a material such as papers, cloths, plastics or metals.

The preparation of pre-sensitized plate (PS plate) may start with electrolyzing or polishing a surface of an aluminum plate to form a plurality of grains required for printing. The light sensitive or heat sensitive radiation sensitive composition is coated on the grains of the aluminum plate to form a radiation sensitive coating. The radiation sensitive coating is baked and cured. Following that, a negative having pre-determined images and texts is transferred to the radiation sensitive coating via exposure and develop process to produce a printing plate for printing the images and texts on printable objects.

In recent years, digital technologies using computer for processing and outputting image data are widely utilized. Various applicable new image output methods are utilized in the market. There are lithographic printing technologies skipping process using a negative. Digital images in a computer are directly transferred to a radiation sensitive coating via expose and develop process to produce printing plate for printing images and texts on printable objects. Thus the operation of plate production is significantly simplified, which increases the printing efficiency and lowers production cost. Such technologies are called Computer to Plate (CTP). The methods for producing the printing plate applicable to CTP have new issues to resolve.

Upon a radiation sensitive composition coated on a surface of an aluminum plate used for lithographic printing is exposed, the exposed portion becomes alkali soluble and is removed during the develop process to form a positive plate. On the other hand, exposed portion is cured and becomes alkali non-soluble to form a negative plate. Under the above two circumstances, the image area accepts ink or is lipophilic and the non-image area accepts water or is hydrophilic. Whether a light-sensing plate is categorized as positive or negative type depends on the radiation sensitive composition coated on the aluminum plate.

The radiation sensitive composition mentioned above mainly composed of the following materials: radiation absorptive dyes (a light sensitive agent or a heat sensitizing agent), acid generators, novolac resins (film forming resins), copolymers, solvents, and other assistants.

The related art disclosed in the U.S. Pat. No. 6,063,544 is a positive plate coated with mixtures of novolac resin or cresol-formaldehyde or polyhydroxystyrene and infrared light absorptive dyes. In addition, the U.S. Pat. No. 5,372,907, 5,372,915, 5,340,699, 5,491,046 disclose plates coated with mixtures of novolac resin, cresol novolac resin, infrared light absorptive dyes or colorant and latent Bronsted acid. When the plates are exposed to infrared light radiation, the latent Bronsted acid is decomposed to generate a material catalyzing crosslinking reactions of different novolac resins (such as a novolac resin and a cresol resin) in order to cure the mixtures in the exposed areas. Further, the exposed printing plate is heated to enhance curing of the exposed coating and becomes insoluble to alkaline developer solution, where the non-exposed area remains soluble to developer solution. The U.S. Pat. No. 5,919,601 discloses a radiation sensitive composition being composed of binder resins, crosslinking agents, thermal-activated latent Bronsted acids (thermal-activated acid generators) and infrared light absorbents. The composition is exposed to infrared light. Then the latent Bronsted acid is decomposed to release acid ions to catalyze crosslinking reactions of binder resins via crosslinking agents.

The disadvantage of the above technologies in common is that the developed image area of the printing plate lacks of integrity and is not durable for printing for a long time which leads to undesirable image resolution and printing qualities.

In order to improve commercial competiveness, printing operators are required to increase plate making efficiency and printing qualities, there is a demand for faster sensitivity of the radiation sensitive coating on a printing plate. In other words, the required exposure energy is desired to be lower and the required exposure time is desired to be shorter. In addition, the exposed portion is desired to be easier removed by a developer solution during develop process. Non-exposed portion is desired to have higher resistance to soak in and washed by a developer solution. That means the non-exposed portion is desired to have higher tolerance on temperature, concentration of the developer solution as well as soaking and washing time during develop process. Whilst, it is also desired to maintain fine resolution, ink absorption and abrasion-resistance of the radiation sensitive coating. Further, it is desired to increase adhesiveness between the radiation sensitive coating and aluminum plate.

There are many patents proposing different views and methods to meet the demands of printing industry. For example, the U.S. Pat. No. 7,425,402 and 7,455,949 modified the phenolic monomeric unit in the structure of the novolac resin or copolymer used in the formula of the radiation sensitive coating. In the phenolic monomeric unit, the imide or thioimide group is bonded to the carbon atom of the phenol group so as to enhance the chemical resistance of the radiation sensitive coating. The U.S. Pat. No. 7,458,320 modified the phenolic monomeric unit in the structure of the novolac resin or copolymer used in the formula of the radiation sensitive coating. In the phenolic monomeric unit, the imide group is bonded to the hydrogen atom of the phenol group or hydrogen atom of the hydroxyl group in the phenol group so as to enhance the chemical resistance and developing latitude of the radiation sensitive coating. The U.S. Pat. No. 7,563,556 illustrates the modified phenolic monomeric unit shown as the structural formula (A). The radiation sensitive coating prepared having the structure generates a more clean image in develop process as a result of less residues generated in the image. 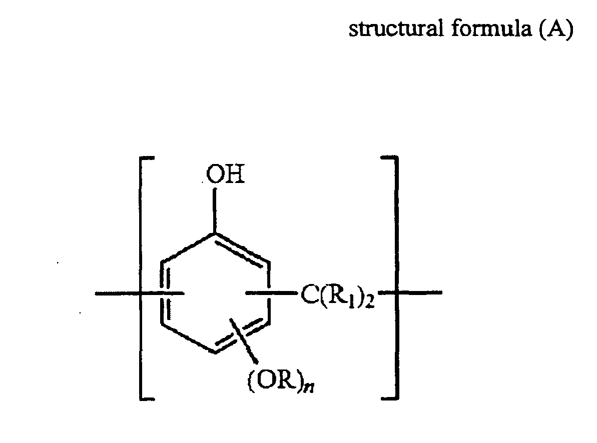 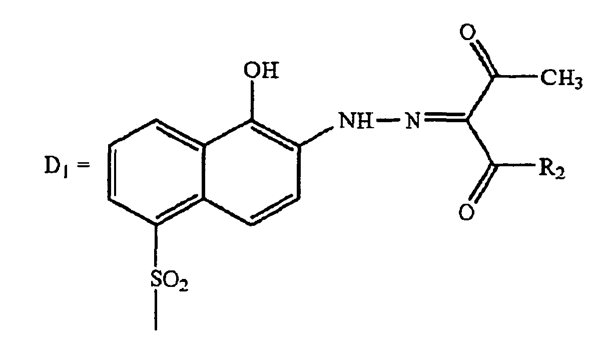 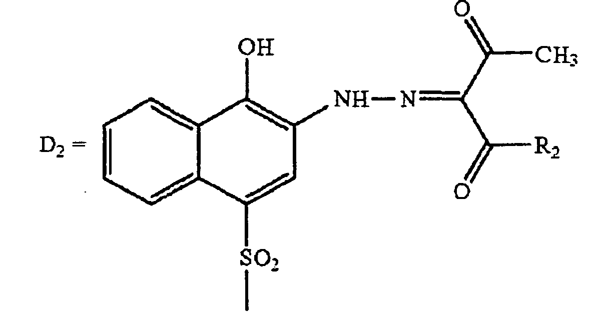 wherein, R is H, D1 or D2; R₁ is H or an alkyl group having C1~C2; n is 1, 2 or 3; R₂ is H or an alkyl group or an alkoxy group having C1~C6.

As described above, technologies disclosed in most patents concern to enhance the characteristics of radiation sensitive coating on a printing plate after the expose and develop process and address less on the developing latitude. Therefore, the invention aims to provide other methods to enhance developing latitude..

The U.S. Pat. No. 5,770,750, U.S. Pat. No. 6,166,151 and U.S. Pat. No. 6,291,077 illustrate the modified method of the novolac resin and the modified novolac resin is applied in coating industry. After extended discussions, the inventor considered that the novolac resin reacts with the lactone structure in the above patents and the developing latitude is enhanced as a result of different chain lengths between hydroxyl groups and the main chain in the novolac resin generating impacts to different levels in the alkaline developer solution in a develop process. Accordingly, the inventor first attempted to prepare film-forming resin modified with a reaction of the novolac resin and the lactone and tested developing latitude.. In the example of the film-forming resin modified with a reaction of caprolactone and a novolac resin, the reaction formula (B) is shown in the following. According reaction formula (B), it is apparent that chain lengths between hydroxyl groups and the main chain differ as the reaction conditions changes (such as mole ratios).

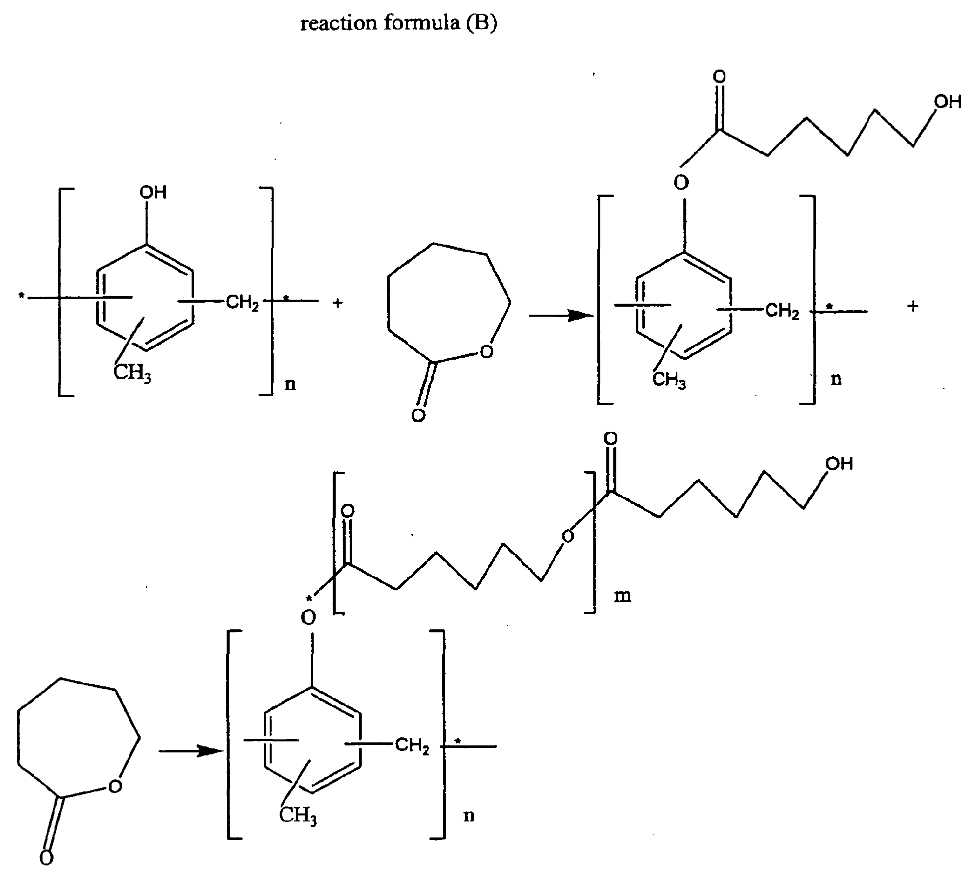

### SUMMARY OF THE INVENTION

The objective of the invention is to provide a radiation sensitive composition. The radiation sensitive composition is coated on an applicable substrate such as a printing board. The coated substrate is baked, exposed and developed to produce an image, which has desirable hardness, abrasion-resistance, adhesiveness, print durability and enhanced developing latitude. In addition, the yield rate and the quality of printing plates are significantly enhanced.

To achieve the above objective, the inventor conducted researches and found a film-forming resin produced by a modification reaction of a novolac resin of formula (I) and a lactone structure of formula (II). The present invention uses the modified film-forming resin in the formula of a radiation sensitive composition for effectively improving developing latitude without affecting hardness, abrasion-resistance, an adhesiveness of a coating of the radiation sensitive composition. 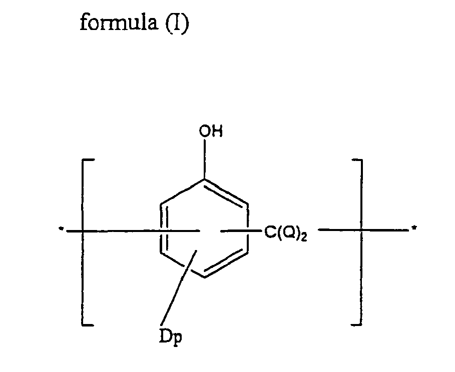 wherein Q is H or an alkyl group having C1~C2; D is H, OH or an alkyl group having C1~C8, a cycloalkyl group, a alkoxy group and a phenyl group, p is an integer of 1, 2 or 3, and n≥1. 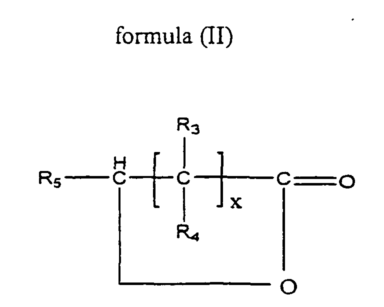 wherein x is an integer of 0~17, R₃, R₄, R₅ respectively are H, an alkyl group having C1~C20, a cycloalkyl group, an alkoxy group and a phenyl group.

The radiation sensitive composition of the present invention further comprises radiation absorptive dyes, copolymer, solvent, surfactant, coloring agent, wetting agent, acid generator or mixtures thereof.

The advantages provided by the radiation sensitive composition of the present invention are as follows: the film-forming resin is produced by a modification reaction of a novolac resin and a lactone structure. The composition comprising film-forming resin is coated on an applicable substrate. The coated substrate is baked, exposed and developed to produce an image, which has desirable hardness, abrasion-resistance, adhesiveness, print durability and enhanced developing latitude. In addition, the yield rate and the quality of printing plates are significantly enhanced.

Because the radiation sensitive composition of the present invention comprises copolymers polymerized by specific monomers which may enhance hardness and adhesiveness, the radiation sensitive composition of the present application may significantly increase hardness, abrasion-resistance and adhesiveness of radiation sensitive coating while maintaining exposure sensitivity and developing latitude. Thus, print durability of lithographic printing is considerably enhanced.

### DETAILED DESCRIPTION OF THE INVENTION

The present invention provides a radiation sensitive composition used for forming an image layer. The composition is used as a coating on a positive and negative plate. The present invention is characterized in that the composition comprising a film-forming resin produced by a modification reaction of a novolac resin of formula (I) and a lactone structure of formula (II), the structure is: 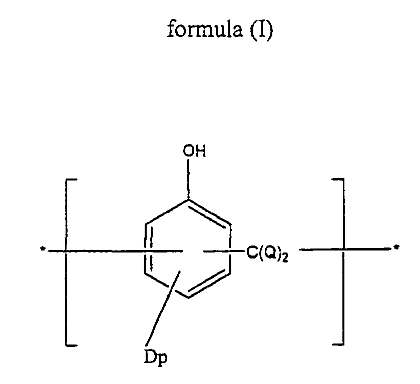 wherein Q is H or an alkyl group having C1~C2; D is H, OH, an alkyl group having C1~C8, a cycloalkyl group, a alkoxy group and a phenyl group; p is an integer of 1, 2 or 3. 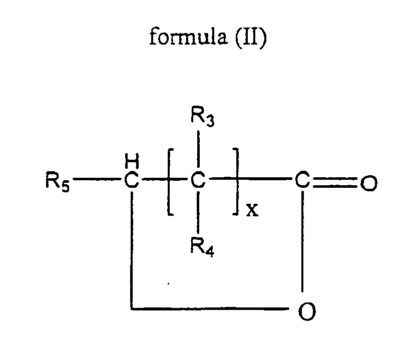 wherein x is an integer of 0~17; R₃, R₄, R₅ respectively are H, an alkyl group having C1~C20, a cycloalkyl group, an alkoxy group and a phenyl group.

The film-forming resin is modified with a reaction of a novolac resin and a lactone structure and the structure is: 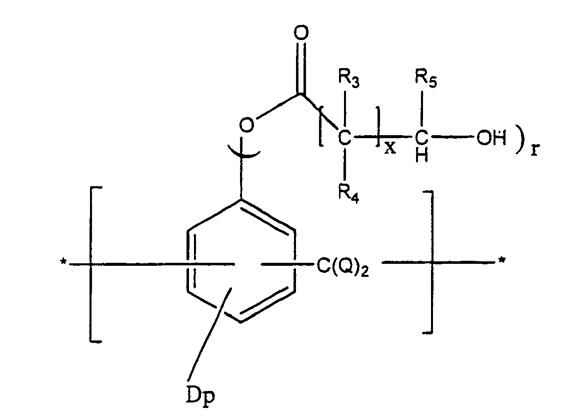 wherein, Q is H, an alkyl group having C1~C2; D is H, OH,an alkyl group having C1~C8, a cycloalkyl group, a alkoxy group and a phenyl group; p is an integer of 0, 1, 2 or 3; and r is an integer of 1~4, and p+r=4; x is an integer of 0~7; R₃, R₄, R₅ respectively are H, an alkyl group having C1~C20, a cycloalkyl group, an alkoxy group and a phenyl group.

The radiation sensitive composition is composed of a mixture comprising 30~95 weight percent of a film-forming resin (film former) produced by a modification reaction of a novolac resin or poly hydroxyl (methyl) styrene resin and lactone, 4~65 weight percent of a copolymer, 0.1~45 weight percent of a radiation absorptive dye, 0.1~15 weight percent of an acid generator. The composition of the invention further comprises solvents and additive agents.

The present invention also provides a method for producing an image. The method comprises: (I) coating an image layer on a substrate, wherein the imaging layer is composed of a film-forming resin produced by a modification reaction of novolac resin with lactone, a copolymer, a radiation absorptive dye, an acid generator, wherein the imaging layer further comprises solvents and an additive agents; (II) drying the imaging layer; (III) exposing an image forming area of the imaging layer under an energy source emitting sufficient light beams; wherein the light beams can be UV/Vis light beams with a wave length of 320nm~750nm or IR light beams with a wave length of 750nm~1350nm; and (IV) soaking and washing the image forming area with developer for removing the exposed portion from the substrate.

The novolac resins applicable to the present invention include phenol, o-cresol, m-cresol, p-cresol, 2-naphthol, phenol derivatives or a mixture composed of at least two above mentioned compounds, and aldehyde condensation products such as formaldehyde, acetaldehyde, other aliphatic or aromatic aldehyde, etc. The product, the novolac resin, preferably has a weight average molecular weight in a range between 300 ~ 400,000.

The copolymers applicable to the present invention are composed of a methacrylic acid monomer such as methyl methacrylate (MMA), methacrylic acid (MAA), lauryl methacrylate, isobutyl methacrylate, ethyl methacrylate, butyl methacrylate, ethylhexyl methacrylate, dodecyl 2-methylacrylate, etc., styrene and the derivatives such as α- methyl styrene, 4-hydroxystyrene, 4-hydroxymethylstyrene, Methyl styrene with halogen, maleic anhydride, acrylonitrile and N-substituted maleimide monomer, wherein N-substituted maleimide monomer is N-phenylmaleimide, 4-hydroxyphenylmaleimide, N-(2,3-dimethylphenyl) maleimide. The above monomers are polymerized based on different composition combination and ratios used as a light sensing coating.
The radiation absorptive dyes applicable to the present invention largely include light sensitive dyes and heat sensitive dyes. The light sensitive dyes mainly include 1,2-naphthoquinonediazide-4-sulfonyl chloride or 1,2- naphthoquinonediazide-5-sulfonyl chloride and esterification condensates of polyhydroxy compounds. The heat sensitive dyes mainly include dyes with wave length of 700-900nm, such as cyanine dyes, polymethine dyes, naphthoquinone dyes, phthalocyanine dyes, anthraquinone dyes, or indoaniline metal complex dyes, etc.

Acid generators applicable to the present invention generate protic acids after exposing to heat or light generated by light within an infrared light spectrum. The generated protic acid is used in photo decomposition of light sensing materials of the copolymers in the exposed area. Compounds generating protic acids via thermo chemistry are disclosed in U.S. Pat. No. 5,466,557. The US patent is incorporated in the present application as references. Applicable compounds include haloalkyl compounds such as haloalkyl-substituted s-triazinehaloalkyl, haloalkyl 2-pyrone, haloalkyl oxazole, haloalkyl oxadiazole and haloalkyl thiazole, etc. These compounds generally have functional group such as trihalomethyl, which may produce polyhalomethyl-substituted hydrohalic acid when receiving the heat of infrared radiation. The most applicable acid generators may be selected from a variety of (trichloromethyl) -triazine ,that is, it is preferred to select from, but not to limit to 2,4,6-(trichloromethyl)-1,3,5-triazine,
2,4-(trichloromethyl)-6-phenyl-1,3,5-triazine,
2-(4-Methoxyphenyl)-4,6-bis(trichloromethyl)-1,3,5-triazine,
2,4-(trichloromethyl)-6-(3,5-methoxyphenyl)-1,3,5-triazine,
2,4-(trichloromethyl)-6-naphenyl-1,3,5-triazine,
2,4-(trichloromethyl)-6-(methoxynaphenyl)-1,3,5-triazine,
2,4-(trichloromethyl)-6-(styryl)-1,3,5-triazine and
2,4-(trichloromethyl)-6-(4-methoxystyryl)-1,3,5-triazine, etc.

The solvent used by the present invention is selected from ethanols, esters, ketones, ethers, carboxamides, aromatics and mixtures thereof and in particular 1-methoxyl-2- ethanol, 1-methoxyl-2- propanol, ethyl glycol acetate, ethyl acetate, acetone, butanone, diisobutyl ketone, methyl isobutyl ketone, cyclohexanone, toluene, xylene, 1-propanol, isopropanol, tetrahydrofuran, butyrolactone, methyl lactate, dimethyl amide and mixtures thereof.

The additive agents used by the present invention include additives such as surfactants, coloring agents and wetting agents. The coloring agent is used for differentiating image on the printing plate after the develop process. The coloring agent applicable to the present invention include oil-soluble dyes or basic dyes such as crystal violet, malachite green, victoria blue, methylene blue, ethyl violet, oil blue 603/613, or rhodamine b, etc. and the mixture thereof.

<Example 1> Modification of the film-forming resin 40g novolac resin -Rezicure5200 (high purity degree of a m-cresol novolac resin from SpecialCheme Company), 12g novolac resin -DURITE® SD-1508 (a novolac resin composed mainly of bisphenol from Hexion Company), 10.0g caprolactone and 200g xylene are placed in a 500ml four-neck reaction flask. The four-neck reaction flask are installed with a stirring blade, a thermometer, reflux condenser and connected to nitrogen. The mixture is heated up to 120°C until the novolac resin is totally dissolved. Add 2g of stannous octoate (T-9 catalyst) (0.1 %). Then add 2g sulfuric acid (0.1 %). The mixture is heated up to and controlled at 130 to allow the mixture reacts. When the reaction was complete, the xylene was distilled off under reduced pressure to give the modified film-forming (sample No. N-1) resin.

### <Example 2> Modification of the film-forming resin

The modification method of the present example is largely identical with the modification method of the Example 1, wherein the difference is that the present examples uses 8.0g caprolactone The procedure of Example 1 was repeated except that 10g caprolactone was replaced with 8.0g caprolactone and the sample No. of the modified film-forming resin is N-2.

### <Example 3> Modification of the film-forming resin

The modification method of the present examples is largely identical with the modification method of the Example 1, wherein the difference is that the present examples uses 6.0g caprolactone and the sample No. of the modified film-forming resin is N-3. The procedure of Example 1 was repeated except that 10g caprolactone was replaced with 6.0g caprolactone and the sample No. of the modified film-forming resin is N-3.

### <Example 4> Modification of the film-forming resin

The modification method of the present example is largely identical with the modification method of the Example 1, wherein the difference is that the present examples uses 7.5g butyrolactone and the sample No. of the modified film-forming resin is N-4. The procedure of Example 1 was repeated except that 10g caprolactone was replaced with 7.5g butyrolactone and the sample No. of the modified film-forming resin is N-4.

### <Example 5> Modification of the film-forming resin

The modification method of the present example is largely identical with the modification method of the Example 1, wherein the difference is that the present examples uses 6.0g butyrolactone and the sample No. of the modified film-forming resin is N-5. The procedure of Example 1 was repeated except that 10g caprolactone was replaced with 6.0g butyrolactone and the sample No. of the modified film-forming resin is N-5.

### <Example 6> Modification of the film-forming resin

The modification method of the present example is largely identical with the modification method of the Example 1, wherein the difference is that the present examples uses 4.5g butyrolactone and the sample No. of the modified film-forming resin is N-6. The procedure of Example 1 was repeated except that 10g caprolactone was replaced with 4.5g butyrolactone and the sample No. of the modified film-forming resin is N-6.

### <Example 7>The synthesis method of the copolymer

35g PMI, 30g MMA, 35g AN, 1g initiator (Azobisisobutyronitrile, AIBN) and 200g solvent (Dimethyl Formamide, DMF) are placed in a 500ml four-necked flask. The four-necked flask equipped with a stirring blade, a thermometer, a reflux condenser and a nitrogen inlet. The reaction temperature is controlled at 70 for 24 hours. After cooling to room temperature, the resulting reaction mixture was poured into 6kg of water to precipitate the copolymer in the form of powder. The copolymer is filtered and dried to give the copolymer (copolymer P-1). Copolymers with other different compositions can also beobtained by the above method.

### <Example 8> This example is outside the scope of the claims. The preparation of a heat sensitive radiation sensitive composition and a CTP printing plate

The heat sensitive radiation sensitive composition of the present example is generated by stirring the following components until the components are totally dissolved in the solvents. The components include 20g novolac resin -Rezicure5200, 6g novolac resin -DURITE® SD-1508, 9.0g copolymer (copolymer P-1), 0.8g radiation absorptive dyes -cyanine dyes IR dye 23b[PCAS] (from PCAS Company and reacted under IR light), 0.24g
2,4-(trichloromethyl)-6-(4-methoxystyryl)-1,3,5-triazine, 0.5g coloring agent victoria blue, 0.5g coloring agent -crystal violet lactone, 6ml solvent ethyl acetate, and 104g solvent ethyl glycol acetate.

Provide an aluminum plate with hydrophilic treatment. The above mentioned heat sensitive radiation sensitive composition is coated on the aluminum plate with coating thickness of 1.8 g/m². The coated aluminum plate is baked under 100°C for 4 minutes and cured under 50°C for 24 hours to generate a positive heat sensitive CTP printing plate.

### <Example 9> The preparation of a heat sensitive radiation sensitive composition and a CTP printing plate

The preparation of the printing plate in the present example is largely identical with the preparation of the positive heat sensitive CTP printing plate in the example 8, wherein the difference is that 20g novolac resin -Rezicure5200 and 6g novolac resin -DURITE® SD-1508 are replaced by 26g modified film-forming resin (N-1). The procedure of Example 8 was repeated except that 20g novolac resin -Rezicure5200 and 6g novolac resin -DURITE® SD-1508 was replaced with 26g modified film-forming resin (N-1).

### <Example 10> The preparation of a heat sensitive radiation sensitive composition and a CTP printing plate

The preparation of the printing plate in the present example is largely identical with the preparation of the positive heat sensitive CTP printing plate in the example 9, wherein the difference is that the modified film-forming resin used is the sample N-2. The procedure of Example 9 was repeated except that modified film-forming resin (N-1) was replaced with modified film-forming resin (N-2).

### <Example 11> The preparation of a heat sensitive radiation sensitive composition and a CTP printing plate

The preparation of the printing plate in the present example is largely identical with the preparation of the positive heat sensitive CTP printing plate in the example 9, wherein the difference is that the modified film-forming resin used is the sample N-3. The procedure of Example 9 was repeated except that modified film-forming resin (N-1) was replaced with modified film-forming resin (N-3).

### <Example 12> The preparation of a heat sensitive radiation sensitive composition and a CTP printing plate

The preparation of the printing plate in the present example is largely identical with the preparation of the positive heat sensitive CTP printing plate in the example 9, wherein the difference is that the modified film-forming resin used is the sample N-4. The procedure of Example 9 was repeated except that modified film-forming resin (N-1) was replaced with modified film-forming resin (N-4).

### <Example 13> The preparation of a heat sensitive radiation sensitive composition and a CTP printing plate

The preparation of the printing plate in the present example is largely identical with the preparation of the positive heat sensitive CTP printing plate in the example 9, wherein the difference is that the modified film-forming resin used is the sample N-5. The procedure of Example 9 was repeated except that modified film-forming resin (N-1) was replaced with modified film-forming resin (N-5).

### <Example 14> The preparation of a heat sensitive radiation sensitive composition and a CTP printing plate

The preparation of the printing plate in the present example is largely identical with the preparation of the positive heat sensitive CTP printing plate in the examples 9, wherein the difference is that the modified film-forming resin used is the sample N-6. The procedure of Example 9 was repeated except that modified film-forming resin (N-1) was replaced with modified film-forming resin (N-6).

The positive heat sensitive CTP printing plates generated in Example 8 to Example 14 are put through exposure and develop tests. The develop test uses developer solution Kodak premium (from Kodak Company), at temperature of 23 and develop time is 30 seconds. The 50% dot formation test uses iCPlate2 [X-rite] printing plate measuring apparatus (from X-Rite Company). The results are categorized and listed in the following.

| No./Energy (mJ/cm²) | 146 | 155 | 165 | 176 | 188 | 203 | 220 |
|---|---|---|---|---|---|---|---|
| Example 8 | 52.5 | 52.0 | 51.3 | 50.4 | 49.5 | 49.1 | 48.0 |
| Example 9 | 52.1 | 51.5 | 49.8 | 50.4 | 49.4 | 48.6 | 47.9 |
| Example 10 | 52.3 | 51.2 | 51.4 | 49.9 | 49.2 | 48.0 | 47.5 |
| Example 11 | 52.1 | 51.5 | 51.1 | 49.5 | 49.4 | 49.8 | 47.9 |
| Example 12 | 52.8 | 51.5 | 49.8 | 49.5 | 49.2 | 49.8 | 47.5 |
| Example 13 | 52.1 | 51.2 | 51.4 | 49.9 | 50.1 | 48.6 | 47.5 |
| Example 14 | 53.0 | 52.5 | 51.1 | 49.5 | 50.1 | 48.0 | 48.5 |

The X-rite 528 color meter (from X-rite Company) measures thinning difference of samples from Example 8 to Example 14 (which means the difference of light sensing layer before and after the test). The reference point for measuring clean point is concluded by adding alcohol drops onto the plate until there is no color change and then the corresponding clean point is measured. Typically the light sensing layer has colorants, such as blue colorant. When the light sensing layer has residues on the plate, the alcohol dissolves the colorant within the light sensing layer. In other words, alcohol is used for testing if there are residues of the light sensing layer on the plate. In addition, finger touch is the main reason causing printing surface falling off or scratching. A surface hardness test is applied to the product graded by standard pencil hardness to differentiate product surface hardness. The test uses 3M#610 tape sticking to printing patterns. The tape is pressed firmly to assure no air is left between the sticking surface between the tape and the printing patterns. One minute after the tape sticking to the printing patterns, the tape is peeled from the printing patterns. If the printing patterns are not damaged, the adhesiveness is OK. If the printing patterns are torn by the tape, the adhesiveness is NG. The abrasion-resistance test uses abrasion tester and wet test method wherein the surface is rubbed repeatedly for 100 times and observed if any damage occurred to the surface. The result is graded by three categories undesirable, normal and desirable. Lastly, accelerated abrasion printing conditions are applied to test the maximum printing amount with commercially acceptable quality. The results are categorized and listed in the following.

| No. | Thinning Difference Percentage (%) | Clean point | Hardness (H) | adhesiveness | abrasion-resistance | print durability |
|---|---|---|---|---|---|---|
| Example 8 | 0.11 | 146mJ/ cm² | 4H | NG | undesirable | 45000 |
| Example 9 | 0.13 | 146mJ/cm² | ≥4H | OK | desirable | 120000 |
| Example 10 | 0.12 | 146mJ/cm² | ≥4H | OK | desirable | 110000 |
| Example 11 | 0.13 | 146mJ/cm² | ≥4H | OK | desirable | 130000 |
| Example 12 | 0.12 | 146mJ/cm² | ≥4H | OK | desirable | 110000 |
| Example 13 | 0.12 | 146mJ/cm² | ≥4H | OK | desirable | 120000 |
| Example 14 | 0.12 | 146mJ/cm² | ≥4H | OK | desirable | 110000 |

The develop test uses developer solution Kodak premium (from Kodak Company), at temperature of 23 and develop time is 45 seconds. The 50% dot formation test uses iCPlate2 [X-rite] printing plate measuring apparatus (from X-Rite Company). The X-rite 528 color meter (from X-rite Company) measures thinning difference of samples from Example 8 to Example 14. The reference point for measuring clean point is concluded by adding alcohol drops onto the plate until there is no color change and then the corresponding clean point is measured. The results are categorized and listed in the following.

| No/Energy (mJ/cm²) | Clean point | 130 | 146 | 155 | 165 | 176 | 188 | 203 | Thinning Difference Percentage (%) |
|---|---|---|---|---|---|---|---|---|---|
| Example 8 | 130 | 46.2 | 45.7 | 45.0 | 44.2 | 43.5 | 42.8 | 42.1 | 0.32 |
| Example 9 | 130 | 49.8 | 48.7 | 48.1 | 47.3 | 46.2 | 45.6 | 45.1 | 0.21 |
| Example 10 | 130 | 50.2 | 49.5 | 48.9 | 48.2 | 47.4 | 46.9 | 45.9 | 0.19 |
| Example 11 | 130 | 50.7 | 50.1 | 49.7 | 48.5 | 48.0 | 47.4 | 47.0 | 0.19 |
| Example 12 | 130 | 49.9 | 49.4 | 48.7 | 47.8 | 47.2 | 46.6 | 46.3 | 0.20 |
| Example 13 | 130 | 50.0 | 49.1 | 48.5 | 48.0 | 47.6 | 47.3 | 46.9 | 0.19 |
| Example 14 | 130 | 49.7 | 48.7 | 48.3 | 47.6 | 47.2 | 46.6 | 46.1 | 0.18 |

The develop test uses developer solution Kodak premium (from Kodak Company), at temperature of 25 and develop time is 30 seconds. The 50% dot formation test uses iCPlate2 [X-rite] printing plate measuring apparatus (from X-Rite Company). The X-rite 528 color meter (from X-rite Company) measures thinning difference of samples from Example 8 to Example 14. The reference point for measuring clean point is concluded by adding alcohol drops onto the plate until there is no color change and then the corresponding clean point is measure. The results are categorized and listed in the following.

| No/Energy (mJ/cm²) | Clean point | 130 | 146 | 155 | 165 | 176 | 188 | 203 | Thinning Difference Percentage (%) |
|---|---|---|---|---|---|---|---|---|---|
| Example 8 | 130 | 46.0 | 45.3 | 45.1 | 44.5 | 43.4 | 42.8 | 42.3 | 0.35 |
| Example 9 | 130 | 49.5 | 48.3 | 48.4 | 47.1 | 46.0 | 45.7 | 45.2 | 0.22 |
| Example 10 | 130 | 49.9 | 49.3 | 48.8 | 48.3 | 47.3 | 46.5 | 45.4 | 0.18 |
| Example 11 | 130 | 50.5 | 50.2 | 49.6 | 48.6 | 48.1 | 47.4 | 47.1 | 0.19 |
| Example 12 | 130 | 50.1 | 49.7 | 48.8 | 47.7 | 47.1 | 46.8 | 46.2 | 0.21 |
| Example 13 | 130 | 50.2 | 49.6 | 48.4 | 48.1 | 47.5 | 47.0 | 46.4 | 0.20 |
| Example 14 | 130 | 49.6 | 48.5 | 48.2 | 47.9 | 47.3 | 46.9 | 46.3 | 0.17 |

According to the above data, it is concluded that the positive heat sensitive CTP printing plates added with the modified film-forming resin of the present invention have high sensitivity and high alkali resistance. The differences presented in the 50% dot formation tests is small given the develop time is extended and develop temperature is raised. Thus, the added modified film-forming resin effectively enhances hardness, adhesiveness, abrasion-resistance and print durability of CTP printing plates and it is concluded that the modified film-forming resin improves the yield rate and the quality of CTP printing plates.

## Claims

1. A radiation sensitive composition for applying on a heat sensitive CTP printing plate to form an image layer **characterized in that** the composition is composed of a mixture comprising (a) 30∼95 wt% of a film-forming resin produced by a modification reaction of a novolac resin of formula (I) and a lactone structure of formula (II), (b) 4∼65 wt% of a copolymer, (c) 0.1∼45 wt% of a radiation absorptive dye, (d) 0.1∼15 wt% of an acid generator, in which the structures of formula (I) and formula (II) are: 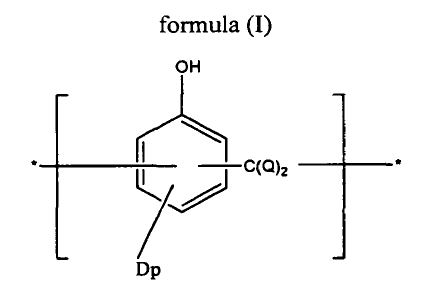 wherein Q is H, an alkyl group having C1∼C2; D is H, OH, an alkyl group having C1∼C8, a cycloalkyl group, a alkoxy group and a phenyl group; p is an integer of 1, 2 or 3; and 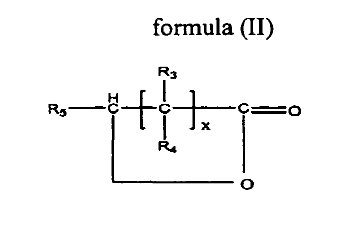 wherein x is an integer of 0∼17; R₃, R₄, R₅ respectively are H, an alkyl group having C1∼C20, a cycloalkyl group, an alkoxy group and a phenyl group.

2. The radiation sensitive composition of claim 1, wherein the film-forming resin is a resin produced by a novolac resin modified with lactone, the structure is: 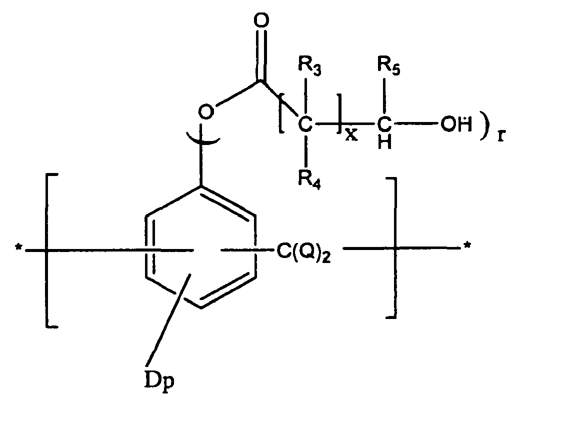 wherein, Q is H, an alkyl group having C1∼C2; D is H, OH, an alkyl group having C1∼C8, a cycloalkyl group, a alkoxy group and a phenyl group; p is a integer of 0, 1, 2 or 3; r is an integer of 1∼4, and p+r=4; x is an integer of 0∼17; R₃, R₄, R₅ respectively are H, an alkyl group having C1∼C20, a cycloalkyl group, an alkoxy group and a phenyl group.

3. The radiation sensitive composition of claim 1, which further comprises solvent, surfactant, coloring agent, wetting agent or mixtures thereof.

## Patentansprüche

1. Strahlungsempfindliche Zusammensetzung zum Auftragen auf eine wärmeempfindliche CTP-Druckplatte zur Bildung einer Bildschicht, **dadurch gekennzeichnet, dass** die Zusammensetzung zusammengesetzt ist aus einer Mischung, umfassend (a) 30-95 Gew.-% eines filmbildenden Harzes, hergestellt durch eine Modifikationsreaktion eines Novolakharzes der Formel (I) und einer Lactonstruktur der Formel (II), (b) 4-65 Gew.-% eines Copolymers, (c) 0,1-45 Gew.-% eines strahlungsabsorptionsfähigen Farbstoffs, (d) 0,1-15 Gew.-% eines Säuregenerators, wobei die Strukturen der Formel (I) und Formel (II) wie folgt sind: 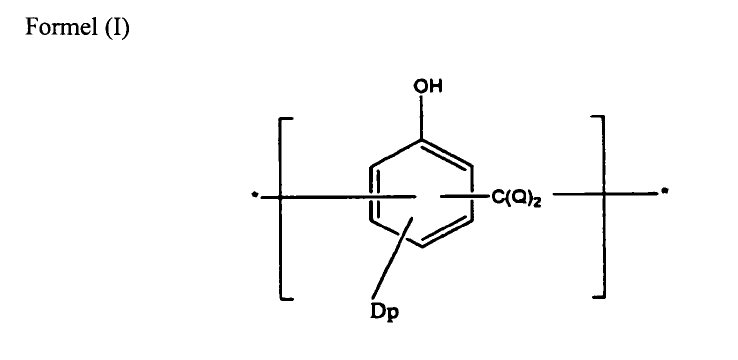 worin Q H, eine Alkylgruppe mit C1-C2 ist; D H, OH, eine Alkylgruppe mit C1-C8, eine Cycloalkylgruppe, eine Alkoxygruppe und eine Phenylgruppe ist; p eine ganze Zahl von 1, 2 oder 3 ist; und 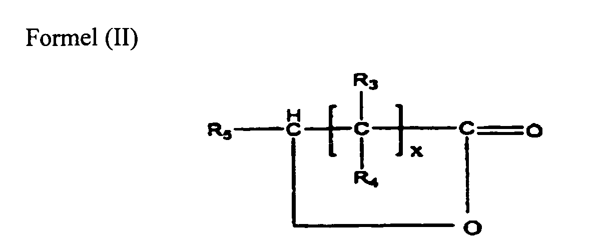 worin x eine ganze Zahl von 0-17 ist; R₃, R₄, R₅ jeweils H, eine Alkylgruppe mit C1-C20, eine Cycloalkylgruppe, eine Alkoxygruppe und eine Phenylgruppe sind.

2. Strahlungsempfindliche Zusammensetzung nach Anspruch 1, wobei das filmbildende Harz ein Harz ist, hergestellt durch ein Novolakharz, modifiziert mit Lacton, das die Struktur besitzt: 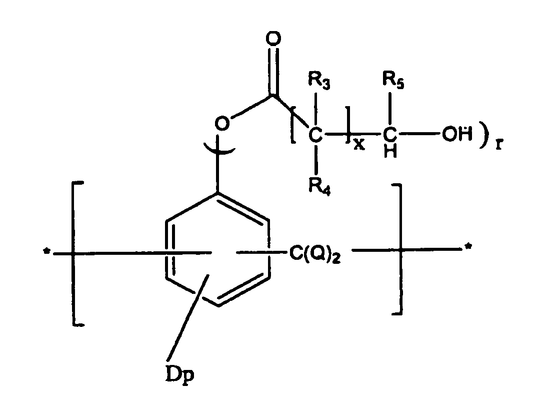 worin Q H, eine Alkylgruppe mit C1-C2 ist; D H, OH, eine Alkylgruppe mit C1-C8, eine Cycloalkylgruppe, eine Alkoxygruppe und eine Phenylgruppe ist; p eine ganze Zahl von 0, 1, 2 oder 3 ist; r eine ganze Zahl von 1-4 ist, und p+r=4; x eine ganze Zahl von 0-17 ist; R₃, R₄, R₅ jeweils H, eine Alkylgruppe mit C1-C20, eine Cycloalkylgruppe, eine Alkoxygruppe und eine Phenylgruppe sind.

3. Strahlungsempfindliche Zusammensetzung nach Anspruch 1, welche weiterhin Lösungsmittel, Tensid, Färbemittel, Benetzungsmittel oder Mischungen davon umfasst.

## Revendications

1. Composition sensible aux rayonnements pour une application sur une plaque d'impression CTP thermosensible pour forme d'une couche image **caractérisée en ce que** la composition se compose d'un mélange comprenant (a) de 30 à 95 % en poids d'une résine filmogène produite par une réaction de modification d'une résine novolac de formule (I) et d'une structure lactone de formule (II), (b) de 4 à 65 % en poids d'un copolymère, (c) de 0,1 à 45 % en poids d'un colorant absorbeur de rayonnements, (d) de 0,1 à 15 % en poids d'un générateur d'acide, dans lequel les structures de formule (I) et de formule (II) sont : 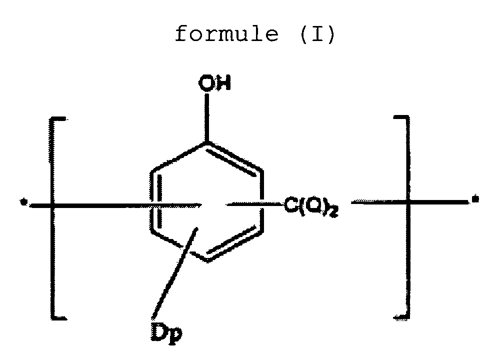 dans laquelle Q est H, un groupe alkyle en C₁∼C₂ ; D est H, OH, un groupe alkyle en C₁∼C₈, un groupe cycloalkyle, un groupe alcoxy et un groupe phényle ; p est un nombre entier valant 1, 2 ou 3 ; et 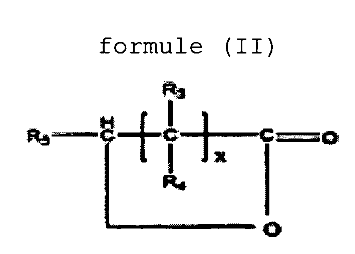 dans laquelle x est un nombre entier valant de 0~17 ; R₃, R₄, R₅ sont respectivement H, un groupe alkyle en C₁∼C₂₀, un groupe cycloalkyle, un groupe alcoxy et un groupe phényle.

2. Composition sensible aux rayonnements selon la revendication 1, dans laquelle la résine filmogène est une résine produite par une résine novolac modifiée par une lactone, dont la structure est : 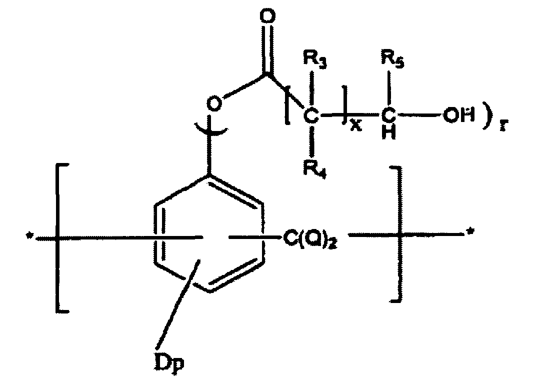 dans laquelle Q est H, un groupe alkyle en C₁∼C₂ ; D est H, OH, un groupe alkyle en C₁∼C₈, un groupe cycloalkyle, un groupe alcoxy et un groupe phényle ; p est un nombre entier valant 1, 2 ou 3 ; r est un nombre entier valant de 1~4, et p+r = 4 ; x est un nombre entier valant de 0∼17 ; R₃, R₄, R₅ sont respectivement H, un groupe alkyle en C₁∼C₂₀, un groupe cycloalkyle, un groupe alcoxy et un groupe phényle.

3. Composition sensible aux rayonnements selon la revendication 1, qui comprend en outre un solvant, un tensioactif, un agent colorant, un agent mouillant ou des mélanges de ceux-ci.
